# DEMANDE DE BREVET EUROPEEN

(11) **EP 0 777 336 A1**
(43) Date de publication de la demande: **04.06.1997**
(21) Numéro de dépôt: 96402544.9
(22) Date de dépôt: 26.11.1996
(51) Int. Cl.: H04B 1/62, H04L 27/20, H03F 1/32

(54) **Emetteur de radiodiffusion à plusieurs états de phase et procédé de correction d'un tel émetteur**

(30) Priorité: 28.11.1995 FR 9514078
(71) Demandeur: THOMCAST, 78700 Conflans-Sainte-Honorine (FR)
(72) Inventeur: Bader, Eric, THOMSON-CSF SCPI, 94117 Arcueil Cedex (FR); Journel, Olivier, Thomson-CSF SCPI, 94117 Arcueil Cedex (FR)
(74) Mandataire: Courtellemont, Alain

(57) **Abrégé**

L'invention concerne les émetteurs de radiodiffusion utilisant la modulation à plusieurs états de phase en quadrature et en particulier à quatre états, dite modulation QPSK.

Pour contrebalancer les défauts de l'amplificateur de sortie (8) une correction de linéarité (4) est effectuée en fréquence intermédiaire et le signal obtenu est repassé en bande de base grâce à un démodulateur QPSK (5) avant d'être transposé en fréquence d'émission grâce à un modulateur QPSK (6) ; cette façon de procéder facilite le filtrage (60) du signal utile à amplifier.

Application, entre autres, aux émetteurs de signaux de radiodiffusion sonore digitale dits signaux DAB.

## Description

La présente invention concerne les émetteurs de radiodiffusion et la correction des défauts de linéarité de leurs amplificateurs de sortie; elle s'applique en particulier aux émetteurs de radiodiffusion de signaux de télévision et aux émetteurs de signaux de radiodiffusion sonore analogique ou digitale utilisant, à partir de signaux en bande de base en quadrature, un passage sur porteuse par une modulation à n états de phase avec n entier supérieur à 1.

Ces émetteurs comportent en sortie des étages d'amplification en classe AB qui, du fait de leur comportement non linéaire, ont tendance à distordre le signal modulant en bande de base. Il est connu, pour y remédier, d'effectuer une précorrection de linéarité de façon à pouvoir utiliser les étages d'amplification en classe AB dans la totalité de leur domaine de fonctionnement possible. En raison de l'impossibilité technique de corriger certains paramètres en bande de base et de la grande difficulté d'effectuer la précorrection en radiofréquence, ces émetteurs comportent, avant leur circuit de transposition en radiofréquence, un modulateur qui assure le passage en fréquence intermédiaire, suivi d'un correcteur de linéarité. Ces émetteurs utilisent un circuit mélangeur pour la transposition en radiofréquence et nécessitent donc un filtrage canal étroit pour réjecter les fréquences indésirables à Fc-Fi et Fc où Fi est la fréquence de l'oscillateur local employé pour le passage en fréquence intermédiaire et Fc la fréquence de l'oscillateur local canal du circuit mélangeur; ceci interdit pratiquement à ces émetteurs toute agilité en fréquence étant donné que tout changement de la fréquence Fc de l'oscillateur local canal nécessite un réajustement du filtrage canal.

La présente invention a pour but d'éviter ces inconvénients tout en continuant à effectuer la correction de linéarité en fréquence intermédiaire.

Selon l'invention ceci est obtenu avec un émetteur de radiodiffusion à modulation à n états de phase avec n entier supérieur à 1, comportant en série un modulateur à n états de phase, en fréquence intermédiaire, un correcteur de linéarité, des moyens de couplage et un amplificateur en radiofréquence, caractérisé en ce que les moyens de couplage comportent en série un démodulateur à n états de phase, en fréquence intermédiaire, avec filtres de sorties et un modulateur à n états de phase, en radiofréquence et en ce qu'un même signal en fréquence intermédiaire est utilisé dans le modulateur en fréquence intermédiaire et dans le démodulateur.

Selon l'invention ceci est obtenu par un procédé de correction d'un émetteur de radiodiffusion à modulation à n états de phase avec n entier supérieur à 1, dans lequel un signal en bande de base subit une correction de linéarité après passage en fréquence intermédiaire puis est transmis après passage en radiofréquence et amplification, caractérisé en ce qu'il consiste, après la correction, à repasser en bande de base, puis à passer directement, avec le signal ainsi obtenu, en radiofréquence.

La présente invention sera mieux comprise et d'autres caractéristiques apparaîtront à l'aide de la description ci-après et des figures d'y rapportant qui représentent:
- la figure 1, un émetteur selon l'art connu,
- la figure 2, un émetteur selon l'invention.

Sur les différentes figures les éléments correspondants sont désignés par les mêmes repères.

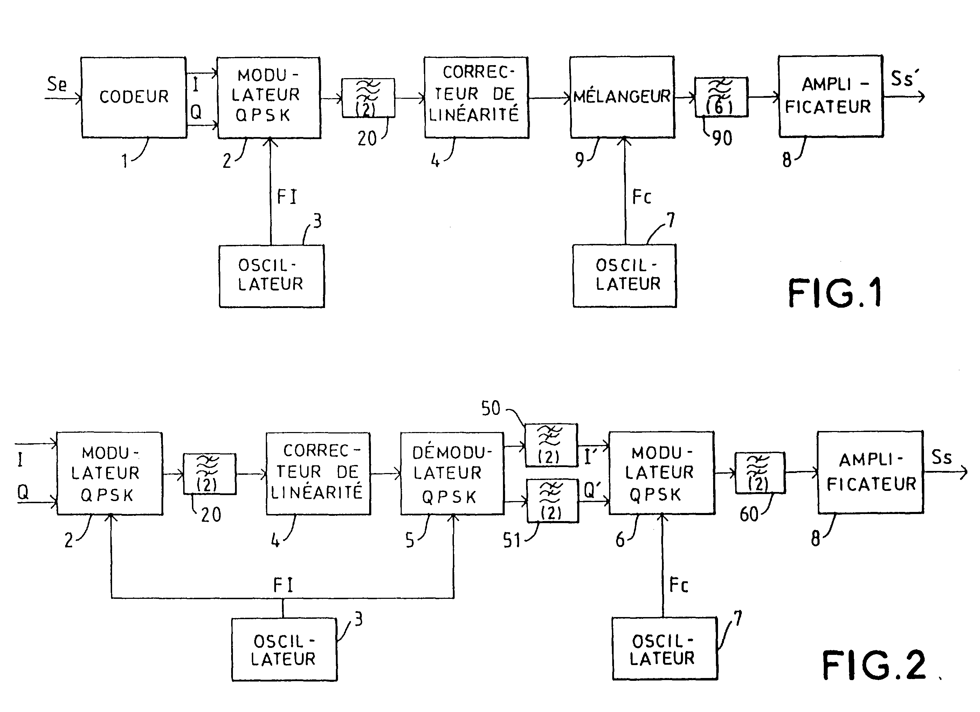

La figure 1 représente un émetteur selon l'art antérieur, pour l'émission d'un signal utile vidéo ou audio, Se. Le signal Se est codé dans un codeur 1 pour donner deux signaux en bande de base, en quadrature, I et Q, d'une largeur de bande de 0,750 MHz pour un signal de radiodiffusion sonore digitale dit signal DAB d'après le sigle de sa traduction en anglais ; digital audio broadcast. Ces deux signaux sont appliqués sur un modulateur à quatre états de phase, 2, dit modulateur QPSK dans ce qui suit, d'après le sigle des mots anglo-saxons Quadrature Phase Shift Keying qui signifient modulation à quatre états de phase. Dans le modulateur 2 les signaux I et Q modulent un signal à fréquence intermédiaire Fl fourni par un oscillateur 3 et donnent ainsi un signal modulé à quatre phases; dans l'exemple décrit Fl =40 MHz et la largeur de bande occupée par le signal DAB est de 2 x 0,750 = 1,5 MHz.

Le modulateur 2 comporte sur sa sortie un filtre passe-bande, 20, d'ordre 2, pour éliminer les signaux parasites produits par la modulation autour de la fréquence 2.FI, alors que le signal utile, à la sortie du modulateur 2 est situé dans une bande de fréquence centrée sur Fl.

Le signal issu du filtre 20 est corrigé dans un correcteur de linéarité 4 de manière à contrebalancer les défauts de linéarité d'un amplificateur 8 auquel il est transmis à travers un mélangeur 9 et un filtre de sortie, 90, du mélangeur. Le correcteur de linéarité "prédistord" le signal en bande de base et crée principalement des produits d'intermodulation d'ordre 3 et 5. Le filtrage en sortie du mélangeur 9 ne doit, en aucun cas, modifier la phase et l'amplitude de ce signal précorrigé, d'où la difficulté de réalisation de cette fonction de filtrage.

Le mélangeur 9 assure la transposition en radiofréquence du signal issu du correcteur, par mélange de ce signal avec un signal à fréquence Fc fourni par un oscillateur 7. Dans l'exemple décrit Fc est de l'ordre de 1,5 GHz. Le mélangeur 9, outre un signal utile autour de la fréquence d'émission Fc + Fl, délivre des signaux parasites et, en particulier, une raie à la fréquence Fc et un signal autour de la fréquence Fc - Fl. Le filtre passe-bande, 90, permet de ne conserver que le signal utile. Mais ce filtre doit, pour cela, présenter une caractéristique à flancs très raides étant donné que les fréquences Fc+ Fl et Fc sont très proches ; dans l'exemple décrit où Fc+ Fl = 1,5 GHz + 40 MHz et où Fc = 1,5 GHz, ce qui fait un écart en fréquence inférieur à 3%, le filtre 90 est un filtre d'ordre 6 qui a donc posé des problèmes de réalisation.

La figure 2 représente un émetteur selon l'invention qui a été réalisé pour remplacer l'émetteur selon la figure 1 mais avec des performances supérieures comme il va apparaître dans ce qui suit.

L'émetteur selon l'invention comporte, comme l'émetteur selon l'art connu, d'une part un codeur, non représenté sur la figure 2, suivi d'un modulateur QPSK, 2, suivi d'un filtre passe-bande 20, d'ordre 2, lui-même suivi d'un correcteur de linéarité 4 et, d'autre part, deux oscillateurs 3 et 7 et un amplificateur 8. Les circuits qui viennent d'être énumérés se correspondent, la différence entre les deux émetteurs se situant dans les circuits placés entre le correcteur de linéarité 4 et l'amplificateur 8. En effet, dans l'émetteur selon la figure 2 le signal corrigé en fréquence intermédiaire dans le correcteur 4, est démodulé dans un démodulateur QPSK, 5, équipé, sur ses sorties, de deux filtres basse bande 50, 51. Deux signaux I' et Q', en bande de base, en quadrature, sont ainsi obtenus et ces signaux qui comportent la correction de linéarité destinée à contrebalancer les défauts de linéarité de l'amplificateur 8 sont directement transposés en radiofréquence dans un modulateur QPSK, 6, qui reçoit comme signal porteur le signal à la fréquence Fc délivré par l'oscillateur 7. Le modulateur 6, outre un signal utile autour de la radiofréquence Fc, délivre des signaux parasites dont les plus proches sont à la fréquence 2.Fc et en bande de base ; ces signaux sont filtrés dans un filtre 60 pour ne garder que le signal utile. Vu l'écart important entre le signal utile et les signaux parasites il n'est pas nécessaire que les flancs de la caractéristique du filtre 60 aient une pente raide; le filtre 60 est donc facile à réaliser, c'est ainsi que, dans l'exemple décrit, il s'agit d'un filtre d'ordre 2 alors qu'il a fallu employer un filtre d'ordre 6 pour le filtre 90 de la figure 1.

De plus cet écart important entre la bande de fréquences du signal utile et les fréquences des signaux parasites les plus proches du signal utile, permet, sans changer le filtre 60, de faire varier la fréquence de l'oscillateur 7 selon la figure 2, et de travailler en agilité de fréquence ; c'est ainsi que, dans l'exemple décrit, l'émetteur fonctionne avec une fréquence Fc de l'oscillateur canal 7 selon la figure 2, qui peut varier de 1,452 à 1,492 GHz, avec des signaux DAB, sans modification du filtre 60.

Il est à noter que, pour que l'émetteur selon la figure 2 fonctionne correctement, il est nécessaire de conserver la quadrature parfaite des signaux I et Q lors des opérations de modulation QPSK et des opérations de démodulation QPSK; la modulation QPSK et la démodulation QPSK doivent donc être synchrones c'est pourquoi, sur la figure 2, c'est un même signal Fl que le modulateur 2 et démodulateur 5 reçoivent d'un même oscillateur 3.

La présente invention n'est pas limitée à l'exemple décrit, c'est ainsi qu'elle s'applique de façon plus générale aux émetteurs de radiodiffusion à n états de phase avec n entier supérieur à 1, étant entendu que la réalisation sera d'autant plus facile que n sera petit.

## Revendications

1. Emetteur de radiodiffusion à modulation à n états de phase avec n entier supérieur à 1, comportant en série un modulateur (2) à n états de phase, en fréquence intermédiaire, un correcteur de linéarité (4), des moyens de couplage et un amplificateur (8) en radiofréquence, caractérisé en ce que les moyens de couplage comportent en série un démodulateur (5) à n états de phase, en fréquence intermédiaire, avec filtres de sorties (50, 51) et un modulateur (6) à n états de phase, en radiofréquence (Fc) et en ce qu'un même signal en fréquence intermédiaire est utilisé dans le modulateur en fréquence intermédiaire (2) et dans le démodulateur (5).

2. Procédé de correction d'un émetteur de radiodiffusion à modulation à n états de phase avec n entier supérieur à 1, dans lequel un signal en bande de base (I, Q) subit une correction de linéarité (4) après passage en fréquence intermédiaire (2) puis est transmis après passage en radiofréquence et amplification (8), caractérisé en ce qu'il consiste, après la correction, à repasser (5) en bande de base, puis à passer directement (6), avec le signal ainsi obtenu (I', Q'), en radiofréquence.
